# EUROPEAN PATENT APPLICATION

(11) **EP 3 901 322 A1**
(43) Date of publication of application: **27.10.2021**
(21) Application number: 19898227.4
(22) Date of filing: 19.12.2019
(51) Int. Cl.: C23C 14/16, C23C 14/24, C23C 14/26, C23C 14/35

(54) **HETEROGENEOUS PLATED STEEL SHEET HAVING EXCELLENT WORKABILITY AND CORROSION RESISTANCE, AND METHOD FOR MANUFACTURING SAME**

(30) Priority: 19.12.2018 KR 20180165283
(71) Applicant: POSCO, Pohang-si, Gyeongsangbuk-do 37859 (KR)
(72) Inventor: KWAK, Young-Jin, Gwangyang-si, Jeollanam-do 57807 (KR); JUNG, Woo-Sung, Gwangyang-si, Jeollanam-do 57807 (KR); HAN, Hyeon-Soop, Gwangyang-si, Jeollanam-do 57807 (KR); KO, Kyoung-Pil, Gwangyang-si, Jeollanam-do 57807 (KR); KIM, Tae-Yeob, Gwangyang-si, Jeollanam-do 57807 (KR)
(74) Representative: Zech, Stefan Markus
(86) International application number: PCT/KR2019/018099
(87) International publication number: WO 2020/130670

(57) **Abstract**

The present invention relates to a plated steel sheet which can be used in vehicles, home appliances, construction materials, and the like, and more specifically, to a heterogeneous plated steel sheet having a galvanized layer formed on one surface thereof and a zinc-magnesium plated layer formed on the other surface thereof.

## Description

### [Technical Field]

The present disclosure relates to a coated steel sheet that may be used in vehicles, home appliances, construction materials, and the like, and more particularly, to a heterogeneous coated steel sheet having a zinc coating layer formed on one surface thereof and a zinc-magnesium coating layer formed on the other surface thereof.

### [Background Art]

The surface treatment technique is a technique for plating the surface of a steel sheet to suppress corrosion of the steel sheet, and a zinc-coated steel sheet using zinc is representative. As a method for manufacturing such a galvanized steel sheet, typically, electrical or hot-dip galvanizing has been utilized.

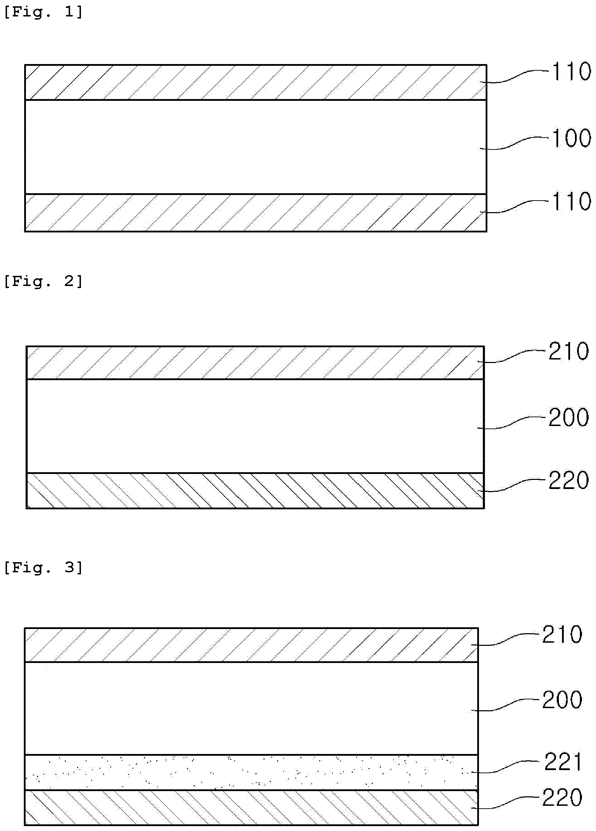

As illustrated in FIG. 1, a plated steel sheet manufactured by the electric or hot dip galvanization has a galvanized layer 110 in which both surfaces of a steel sheet 100 are plated with zinc, and has the same amount of adhesion. In the case of such galvanized steel sheet, post-treatment such as phosphate treatment, chromate or non-chromate treatment, or the like, is performed on a plating layer in order to improve paintability and corrosion resistance. An electrogalvanized steel sheet has an excellent surface appearance and is used as an exterior panel for automobiles. However, it is not advantageous in terms of workability, manufacturing costs and environment during post-plating, and thus, the use of electrogalvanized steel sheet is decreasing overall. A hot-dip galvanized steel sheet is cheaper than electrogalvanizing in terms of manufacturing costs, but is inferior in mechanical properties, formability of plating adhesion, weldability of electrode lifespan during continuous striking, or the like, due to post-plating, compared to electrogalvanizing.

The galvanized steel sheet is soft due to low hardness of the coating layer, and thus, may be easily damaged by external stress during coil transport, and there is a problem in which workability is degraded due to a phenomenon (galling) of zinc sticking to the die during processing. In addition, since the surface friction coefficient is great, it is difficult to apply the galvanized steel sheet to automotive steel sheets subjected to severe processing and having many welding parts.

In order to prevent such a problem, zinc alloy plated steel sheets have emerged, and representatively, alloyed hot-dip galvanized steel sheets and zinc-aluminum alloy plated steel sheets have been introduced.

The alloyed hot-dip galvanized steel sheet is excellent in paintability of coating film adhesion and weldability of electrode lifespan due to formation of Fe-Zn intermetallic compound by alloying reaction of base iron and a galvanized layer. However, due to an Fe-Zn alloy phase (gamma phase) generated by the alloying reaction, there is a problem in workability due to powdering in which the plating layer falls during processing of a steel sheet. In addition, when a sealer used for waterproofing, corrosion prevention, vibration absorption, and welding is attached to a steel sheet, there is a problem in that an Fe-Zn plating layer falls off after bonding the sealer due to an alloy phase generated between Fe-Zn. In addition, since the surface of the Fe-Zn plating layer is not beautiful and the whiteness is not high, it may be difficult to apply as a steel sheet for home appliances, requiring a beautiful surface even after painting or used without painting.

On the other hand, in the case of zinc-aluminum (Zn-Al) alloy plating, since it is difficult to prepare an electroplating solution, manufacturing the zinc-aluminum alloy plated steel sheet by an electroplating method may be difficult, and in the case of manufacturing using a hot-dip plating method, forming different plating layers on both surfaces of a steel sheet may be difficult.

### [Disclosure]

### [Technical Problem]

An aspect of the present disclosure is to provide a heterogeneous coated steel sheet, in which one side of a steel sheet is coated with zinc and the other side thereof is coated with a zinc-magnesium alloy, and which has excellent workability and corrosion resistance, and a method of manufacturing the same.

The subject of the present disclosure to be solved is not limited to the above matters. Additional subjects of the present disclosure are described in the overall content of the specification, and those of ordinary skill in the art to which the present disclosure pertains will have no difficulty in understanding the additional subjects of the present disclosure from the contents described in the specification of the present disclosure.

### [Technical Solution]

According to an aspect of the present disclosure, a heterogeneous coated steel sheet having excellent workability and corrosion resistance, includes a steel sheet; a zinc coating layer attached to one side of the steel sheet; and a zinc-magnesium alloy coating layer attached to the other side of the steel sheet. A coating adhesion amount of the zinc coating layer is 5-60 g/m², a coating adhesion amount of the zinc-magnesium alloy coating layer is 10 to 40 g/m², and a magnesium content of the zinc-magnesium alloy coating layer is 8 to 30 wt%.

According to another aspect of the present disclosure, a method of manufacturing a heterogeneous coated steel sheet having excellent workability and corrosion resistance, includes preparing a steel sheet; levitating a coating material by electromagnetic force in a vacuum chamber to generate zinc deposition vapor, and forming a zinc coating layer having an adhesion amount of 5 to 60 g/m² on one surface of the steel sheet by inducing and ejecting the zinc deposition vapor; and generating zinc-magnesium alloy deposition vapor by levitating a coating material by electromagnetic force in a vacuum chamber, and forming a zinc-magnesium alloy coating layer having an adhesion amount of 10 to 40 g/m² on the other surface of the steel sheet by inducing and ejecting the zinc-magnesium alloy deposition vapor. A Mg content contained in the zinc-magnesium alloy deposition vapor is 8 to 30 weight%.

### [Advantageous Effects]

According to an exemplary embodiment, there is provided a heterogeneous coated steel sheet in which one side of a steel sheet is provided with a zinc coating layer thereon, and the other side thereof is provided with a zinc-magnesium alloy coating layer thereon. In detail, there is provided a heterogeneous coated steel sheet in which excellent workability and corrosion resistance may be secured by optimizing a coating amount of the zinc coating layer and a composition of the zinc-magnesium alloy coating layer.

### [Description of Drawings]

FIG. 1 is a schematic view illustrating a cross section of a galvanized steel sheet manufactured by a related art hot-dip plating method.
FIG. 2 is a schematic diagram illustrating a cross-section of an example of the heterogeneous coated steel sheet according to an exemplary embodiment of the present disclosure.
FIG. 3 is a schematic diagram illustrating a cross-section of an example of a heterogeneous coated steel sheet according to an exemplary embodiment of the present disclosure.
FIG. 4 is a schematic view illustrating a cross-section of an example of a heterogeneous coated steel sheet according to an exemplary embodiment of the present disclosure.
FIG. 5 is a schematic diagram illustrating a cross-section of an example of a heterogeneous coated steel sheet according to an exemplary embodiment of the present disclosure.
FIG. 6 is a schematic diagram of an electromagnetic heating physical vapor deposition apparatus.

### [Best Mode for Invention]

There is provided a heterogeneous coated steel sheet having further excellent workability and corrosion resistance than a coated steel sheet in which both sides of a related art steel sheet are coated with zinc or a zinc alloy. In this case, the heterogeneous steel sheet indicates that one side and the other side of the steel sheet are coated with different kinds of materials, so that respective sides of the steel sheet have different coating layers in one coating steel sheet.

The inventors of the present disclosure have contemplated manners to economically produce products while ensuring corrosion resistance and workability by forming a Zn-Mg coating layer required for products that require high corrosion resistance and galling resistance, compared to the existing coated steel sheet having the same material on both sides, and by forming a zinc coating layer for temporary rust prevention on the other side thereof corresponding to the service coating. To obtain the above effect, a heterogeneous coated steel sheet in which a zinc coating layer is formed on one side of the steel sheet and a zinc-magnesium alloy coating layer is formed on the other side thereof has been derived.

Hereinafter, a heterogeneous coated steel sheet according to an exemplary embodiment will be described in detail with reference to the accompanying drawings. The accompanying drawings are only for understanding of the present disclosure, and are not intended to limit the present disclosure.

As illustrated in FIG. 2, a heterogeneous coated steel sheet according to an example of the present disclosure includes a steel sheet 200; a zinc coating layer 210 attached to one side of the steel sheet; and a zinc-magnesium alloy coating layer 220 attached to the other side of the steel sheet.

In the present disclosure, the steel sheet 200 may be a hot-rolled steel sheet, a cold-rolled steel sheet, an annealed steel sheet, or the like that may be used for home appliances, building materials, automobiles, and the like, and the use and type thereof are not particularly limited.

The zinc coating layer 210 attached to one surface of the steel sheet 210 may preferably have an average grain size of 500 to 800 nm, which is a level of 1/3 of the grain size of an electro-galvanized steel sheet of the related art. Due to the fine grain size thereof, high angle pyramidal surfaces ((103), (102) and (101) surfaces) and a prism (110) surface may be relatively developed and first cultured. A coating adhesion amount of the zinc coating layer 210 may preferably be 5 to 60 g/m², more preferably 10 to 60 g/m². If the coating adhesion amount of the zinc coating layer is less than 5 g/m², there is a problem in which the corrosion resistance of the steel sheet as temporary rust prevention cannot be guaranteed, and if the coating adhesion amount thereof exceeds 60 g/m², it may act disadvantageously in terms of productivity and workability of the zinc coating layer. Therefore, the coating adhesion amount of the zinc coating layer may preferably be 5-60 g/m².

The zinc-magnesium alloy coating layer 220 attached to the other side of the steel sheet 210 may preferably contain 8 to 30% by weight of magnesium (Mg), and the balance of Zn and unavoidable impurities. If the Mg content is less than 8% by weight, the surface appearance may be defective due to color non-uniformity on the surface of the steel sheet, and if it exceeds 30% by weight, there is no advantage in corrosion resistance, economy and workability.

The corrosion potential of the zinc-magnesium alloy coating layer 220 is -1.07V to -1.13V (SCE, Saturated Calomel Electrode), which exhibits a high corrosion potential compared to the existing zinc-iron alloy coated steel sheet (-0.89V SCE) and zinc coating steel sheet (-1.03V SCE), thereby securing excellent corrosion resistance.

On the other hand, it may be preferable that the coating adhesion amount of the zinc-magnesium alloy coating layer 220 is 10 to 40 g/m². If the coating adhesion amount of the zinc-magnesium alloy coating layer is less than 10 g/m², excellent corrosion resistance may not be secured, and if it exceeds 40 g/m², workability is reduced due to powdering properties of the coating layer, which may not be preferable. The zinc-magnesium alloy coating layer 220 is not limited to one layer, and may be formed in a multilayer structure of two or more layers.

The coating structure of the zinc-magnesium alloy coating layer 220 may include various alloy phases, such as Zn single phase, Mg single phase, Mg₂Zn₁₁ alloy phase, MgZn₂ alloy phase, MgZn alloy phase, Mg₇Zn₃ alloy phase, and the like, depending on a composition of magnesium, and fractions of the alloy phases may also differ from each other.

The heterogeneous coated steel sheet according to an exemplary embodiment of the present disclosure provides a coating layer of various structures, in consideration of various usage patterns, uses and the like in composing the zinc-magnesium alloy coating layer, and thus, surface appearance, corrosion resistance, galling resistance, weldability and the like may be secured. For example, by including a Zn layer on the upper and/or lower portion of the zinc-magnesium alloy coating layer, a structure of two to three layers or more may be provided. FIGS. 3 to 5 are cross-sectional views of an example of the heterogeneous coated steel sheet according to an exemplary embodiment of the present disclosure further including a zinc layer 221. In the present disclosure, the 'zinc layer' is distinguished from the 'zinc coating layer' and refers to a layer formed on the zinc-magnesium alloy coating layer side.

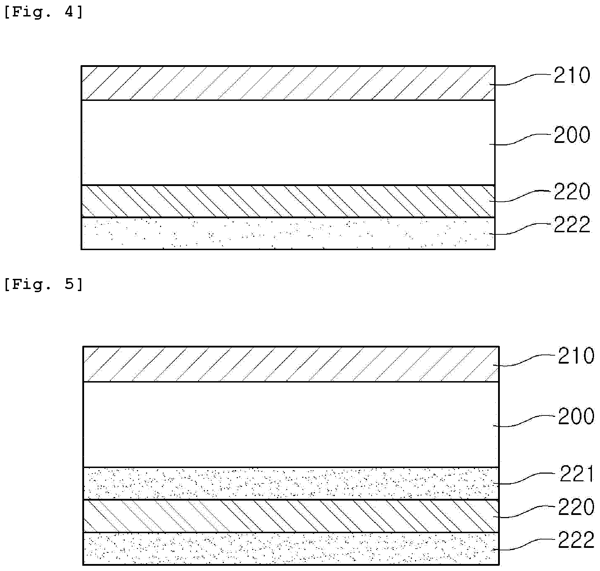

For example, FIG. 3 illustrates that the heterogeneous coated steel sheet further includes the zinc layer 221 between the steel sheet 200 and the zinc-magnesium alloy coating layer 220, and FIG. 4 illustrates that the heterogeneous coated steel sheet further includes a zinc layer 222 on the zinc-magnesium alloy coating layer 220. FIG. 5 illustrates that the zinc layers 221 and 222 between the steel sheet 200 and the zinc-magnesium alloy coating layer 220 and on the zinc-magnesium alloy coating layer 220 are further included.

In FIGS. 3 and 5, the zinc layer 221 present between the zinc-magnesium alloy coating layer 220 and the steel sheet 200 may preferably have a coating adhesion amount of 2 g/m² or more and 10 g/m² or less in consideration of coating adhesion and processability, and may have more preferably 3 g/m² or more and 10 g/m² or less, and most preferably 5 g/m² or more and 10 g/m² or less.

On the other hand, in FIGS. 4 and 5, in the case of the zinc layer 222 present as an uppermost layer on the zinc-magnesium alloy coating layer 220, in consideration of blackening resistance, phosphate treatment and galling resistance, a coating adhesion amount thereof may preferably be 8 g/m² or more and 20 g/m² or less, and may more preferably be 10 g/m² or more and 20 g/m² or less, and may most preferably be 8 g/m² or more and 15 g/m² or less. If the zinc layer 222 having a relatively soft feature is more than 20 g/m², it relatively deteriorates excellent galling resistance of Zn-Mg of an undercoating layer, and thus, the upper limit of the zinc layer 222 may preferably be 20 g/m².

Hereinafter, a method of manufacturing a heterogeneous coated steel sheet according to another embodiment of the present disclosure will be described in detail.

First, a steel sheet is prepared. A process of removing foreign substances, oxide films, or the like that may be present on the surface of the steel sheet, may be included. For example, after degreasing, rinsing, and drying using a 2% or more of low-temperature complex degreasing agent or alkaline degreasing solution, a process of removing foreign substances and natural oxide films on the surface may be performed using plasma and ion beams or the like.

A zinc coating layer is formed on one side of the steel sheet to have a coating adhesion amount of 5 to 60 g/m², and a zinc-magnesium alloy coating layer is formed to have a coating adhesion amount of 10 to 40 g/m² on the other side of the steel sheet. There is no difference in the formation order of the zinc coating layer and the zinc-magnesium alloy coating layer.

The zinc coating layer and the zinc-magnesium alloy coating layer may be preferably formed by an electromagnetic heating physical vapor deposition method having an electromagnetic stirring effect.

To manufacture a coated steel sheet, a physical vapor deposition (PVD) process is used in a vacuum. The disadvantage of the related art PVD process is that the coating material to be vaporized is always present in a liquid state due to the high processing temperature, and thus, the coating speed is limited. For example, in the case of electron beam evaporation using an electron gun, the coating material should be placed in a crucible made of ceramic or copper. In the case of a copper crucible, care should be taken not to melt the copper due to intensive cooling with water or not to vaporize the copper at the same time. A disadvantage of cooling the copper crucible is that a significant amount of heat is lost due to the cooling operation. The use of ceramic crucibles is limited to a coating material that does not chemically react with the material of the crucible at a relatively high temperature. In addition, since most ceramic crucibles have relatively low thermal conductivity, there is a problem in supplying required thermal energy. Therefore, the manufacturing method of the present disclosure may be preferably performed by an electromagnetic heating physical vapor deposition method.

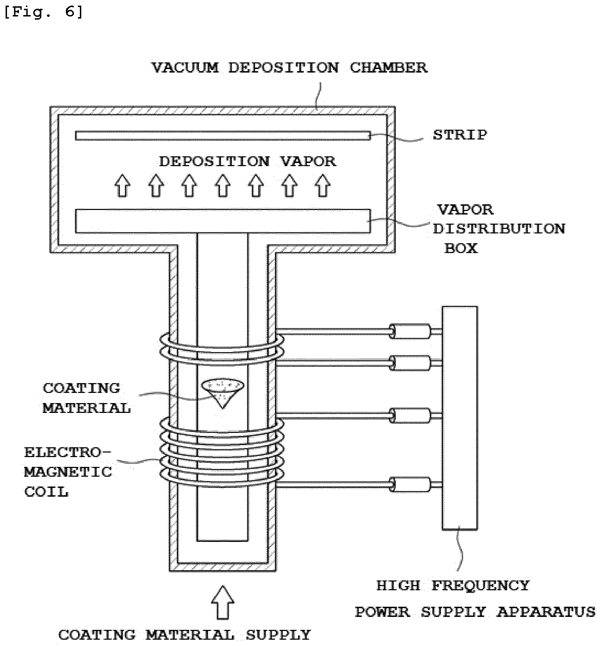

The electromagnetic heating physical vapor deposition method may be performed using a phenomenon, in which when high-frequency power is applied to an electromagnetic coil that generates an alternating magnetic field in a vacuum chamber to generate electromagnetic force, a coating material (zinc, magnesium or the like) is levitated in the air without external help in a space surrounded by an alternating electromagnetic field, and the levitated coating material generates a large amount of metal vapor (zinc deposition vapor, zinc and magnesium deposition vapor). FIG. 6 is a schematic diagram of a device for this electromagnetic levitation physical vapor deposition. Referring to FIG. 6, a large amount of metal vapor formed by the above method is sprayed at high speed onto the surface of the steel sheet through a plurality of nozzles of a vapor distribution box to form a coating layer. In detail, the electromagnetic coil and the vapor distribution box may be installed separately on respective surfaces of the steel sheet, and thus are process equipment having the advantage of coating only one side of the steel sheet and coating a different material on the other side thereof at the same time. In this case, when the temperature of the vapor distribution box is relatively low, since the metal vapor is condensed on the inner wall of the box, it may be preferable to heat the box to a temperature of 800° C or higher to form a coating layer.

On the other hand, the Mg content contained in the zinc-magnesium alloy deposition vapor may preferably be 8 to 30% by weight.

The method may further include a process of forming a zinc layer before and/or after forming the zinc-magnesium alloy coating layer. The zinc layer may preferably be formed by an electromagnetic heating physical vapor deposition method.

The heterogeneous plated steel sheet of the present disclosure obtained by the above method has a significantly fine grain size compared to the related art plated steel sheet, and thus, and has an advantage that the surface appearance is beautiful, the workability is improved due to the increase in hardness, and the corrosion resistance by a Zn-Mg alloy phase due to the Mg content is greatly improved.

### [Mode for Invention]

Hereinafter, embodiments of the present disclosure will be described in detail. The following examples are only for the understanding of the present disclosure, and are not intended to limit the scope of the present disclosure.

### (Example)

A cold-rolled steel sheet including, by weight%, C: 0.125%, Si: 0.102%, Ti: 0.019%, Cu: 0.012%, and the balance of Fe and unavoidable impurities, and having a thickness of 1.20 mm, was prepared. By using the apparatus of FIG. 6 and using different coating adhesion amounts and contents of Mg, a zinc coating layer was formed on one side of the steel sheet and a zinc-magnesium alloy coating layer was formed on the other side thereof. In this case, the coating conditions are as follows.
- Vacuum degree: 3.2X10⁻⁴ mbar
- Vapor distribution box temperature: 1000°C
- Electromagnetic coil current: 1.6kA
- Weight of supplied coating material: Zinc (3kg), Zinc-Magnesium alloy (3.3kg)

On the other hand, in Table 1, a related art example is a zinc coating steel sheet manufactured by an electrogalvanizing or hot dip plating method.

For the coated steel sheet manufactured as described above, corrosion resistance, powdering properties, and galling properties were evaluated, and the results are illustrated together in Table 1.

For corrosion resistance, the corrosion resistance was evaluated after cutting the coated steel sheet into 75mm X 150mm specimens and processing flat plate and cup drawing thereon. In accordance with JIS Z 2371, a salt spray test was conducted to record the time of initial occurrence of red rust, and the relative comparison evaluation with the hot-dip galvanized steel sheet (GI) of 60 g/m² based on the coating adhesion amount on one side was performed. The criteria are as follows.
1: Excellent
2: Normal (GI 60 g/m²) level
3: Defective

For powdering properties, a specimen obtained by cutting a coated steel sheet into a width of 40 mm and a length of 80 mm was mounted on a press tester and subjected to a 60° bending test. After detaching the specimen from the tester and attaching the cellophane tape to the bent part, the tape was unfolded and removed, and then, the tape was attached to a white paper, and the peeling width was measured for comparative evaluation. The criteria are as follows.
1: Excellent (peel width: less than 6.0 mm)
2. Normal (peel width: 6.0-8.0 mm)
3: Defective (peel width: exceeding 8.0 mm)

On the other hand, the galling properties were compared and evaluated by measuring a total of 40 times (120° rotation per rotation) using a rotational friction tester on a specimen obtained by cutting a coated steel sheet into 200mm X 200mm sizes . The friction coefficient value compared to the initial (before the rotational friction test) was compared and evaluated when the rotation was continuously performed using a rotational friction tester, and the criteria are as follows.
1: Excellent (the coefficient of friction after 30 rotations increased by less than 20% compared to the initial value)
2: Normal (the coefficient of friction after 30 rotations increased by less than 40% compared to the initial value)
3: Defective (the coefficient of friction after 30 rotations increased by 50% or more compared to the initial value)

The surface appearance was provided by comparing and evaluating Delta E values obtained by measuring L (whiteness), a (Red-Green), and b (Yellow-Blue) using a color difference meter on specimens cut in size of 600mm X 1000mm. The criteria are as follows.
1: Excellent (Delta E 3 or less between measurement portions within the full width/full length of the coated steel sheet)
2: Normal (Delta E 5 or less between measurement portions within the full width/full length of the coated steel sheet)
3: Defective (exceeding Delta E 5 between measurement portions within the full width/length of the coated steel sheet)

**[Table 1]**

| Classification | Coating layer on one side | | Coating layer on the other side | | | Characteristic evaluation | | | |
|---|---|---|---|---|---|---|---|---|---|
| | Coating layer composition | Adhesion amount (g/m² ) | Coating layer composition | Adhesion amount (g/m²) | Mg Content (wt%) | Surface appearance | Corrosion resistance | Powdering properties | Galling properties |
| Related art example 1 | Zn | 10 | Zn | 10 | - | Good | 3 | 1 | 3 |
| Related art example 2 | Zn | 20 | Zn | 20 | - | Good | 3 | 1 | 3 |
| Related art example 3 | Zn | 40 | Zn | 40 | - | Good | 2 | 1 | 3 |
| Related art example 4 | Zn | 60 | Zn | 60 | - | Good | 2 | 1 | 3 |
| Comparative Example 1 | Zn | 2 | Zn-Mg | 10 | 8 | Good | 3 | 1 | 1 |
| Comparative Example 2 | Zn | 4 | Zn-Mg | 50 | 20 | Good | 3 | 2 | 1 |
| Comparative Example 3 | Zn | 70 | Zn-Mg | 5 | 4 | Non-uniformity | 2 | 1 | 1 |
| Comparative Example 4 | Zn | 70 | Zn-Mg | 50 | 10 | Good | 1 | 1 | 1 |
| Comparative Example 5 | Zn | 60 | Zn-Mg | 40 | 6 | Non-uniformity | 2 | 1 | 1 |
| Comparative Example 6 | Zn | 60 | Zn-Mg | 40 | 40 | Good | 2 | 3 | 2 |
| Inventive Example 1 | Zn | 60 | Zn-Mg | 10 | 10 | Good | 2 | 1 | 1 |
| Inventive Example 2 | Zn | 60 | Zn-Mg | 40 | 8 | Good | 1 | 1 | 1 |
| Inventive Example 3 | Zn | 60 | Zn-Mg | 10 | 30 | Good | 2 | 2 | 1 |
| Inventive Example 4 | Zn | 50 | Zn-Mg | 20 | 25 | Good | 1 | 2 | 1 |
| Inventive Example 5 | Zn | 40 | Zn-Mg | 30 | 15 | Good | 1 | 2 | 1 |
| Inventive Example 6 | Zn | 10 | Zn-Mg | 40 | 12 | Good | 1 | 1 | 1 |
| Inventive Example 7 | Zn | 30 | Zn-Mg | 40 | 8 | Good | 1 | 1 | 1 |
| Inventive Example 8 | Zn | 20 | Zn-Mg | 40 | 15 | Good | 1 | 2 | 1 |
| Inventive Example 9-1 | Zn | 10 | Zn/Zn-Mg | 2/40 | 12 | Good | 1 | 2 | 1 |
| Inventive Example 9-2 | Zn | 10 | Zn/Zn-Mg | 5/40 | 12 | Good | 1 | 1 | 1 |
| Inventive Example 10-1 | Zn | 10 | Zn-Mg/Zn | 40/8 | 12 | Good | 1 | 1 | 1 |
| Inventive Example 10-2 | Zn | 10 | Zn-Mg/Zn | 40/15 | 12 | Good | 1 | 1 | 1 |
| Inventive Example 10-3 | Zn | 10 | Zn-Mg/Zn | 40/22 | 12 | Good | 1 | 1 | 2 |
| Inventive Example 11-1 | Zn | 10 | Zn/Zn-Mg/Zn | 2/40/14 | 15 | Good | 1 | 2 | 1 |
| Inventive Example 11-2 | Zn | 10 | Zn/Zn-Mg/Zn | 6/40/14 | 15 | Good | 1 | 1 | 1 |
| Inventive Example 11-3 | Zn | 10 | Zn/Zn-Mg/Zn | 6/40/9 | 15 | Good | 1 | 1 | 1 |
| Inventive Example 11-4 | Zn | 10 | Zn/Zn-Mg/Zn | 6/40/22 | 15 | Good | 1 | 1 | 2 |

In the 'coating layer composition' in Table 1, Zn/Zn-Mg, Zn-Mg/Zn, and Zn/Zn-Mg/Zn refer to a coating layer having a multi-layer structure, and indicates that it is formed from the surface of the steel sheet. For example, Zn/Zn-Mg indicates that a zinc (Zn) layer is formed and a zinc-magnesium alloy (Zn-Mg) layer is formed thereon, from the surface of the steel sheet.

In the case of the related art, it can be seen that, due to the ductility of zinc, zinc adheres to the mold during continuous molding and the friction coefficient increases, resulting in poor galling resistance and poor corrosion resistance.

Meanwhile, Comparative Examples 1 to 6 correspond to a heterogeneous coated steel sheet of a zinc coating layer and a zinc-magnesium alloy coating layer, and may have the case of satisfactory tendency depending on the composition ratio of adhesion amount of the coating layer, but it can be seen that all conditions cannot be uniformly satisfied. On the other hand, in the case of Comparative Examples 3 and 5, the Mg content of the zinc-magnesium alloy coating layer did not meet the conditions presented in the present disclosure, and thus, it can be confirmed that the surface appearance characteristics are inferior. In the case of Comparative Example 4, all properties were illustrated to be good, but due to an excessive adhesion amount of coating, workability was lowered and there was a disadvantage in terms of costs, and thus, this case was classified as a comparative example.

Inventive Examples 1 to 11 are heterogeneous coated steel sheets having a zinc coating layer and a zinc-magnesium alloy coating layer, and the coating adhesion amount and Mg content are appropriately adjusted, and it can be confirmed that the overall properties are evenly superior to those of the related art examples or comparative examples.

On the other hand, Inventive Examples 9 to 11 illustrate the case in which the zinc-magnesium alloy coating layer and the zinc layer form a multilayer structure. In the case of Inventive Examples 9-1 and 11-1, it can be seen that the adhesion amount of the zinc layer between the steel sheet and the zinc-magnesium alloy coating layer was low, and thus, the powdering properties were somewhat deteriorated. In the case of Inventive Examples 10-3 and 11-4, it can be seen that the adhesion amount of the zinc layer present on the zinc-magnesium alloy coating layer was slightly excessive, and thus, the galling resistance was slightly lowered. Inventive Examples 10-1 and 11-3 are cases in which the adhesion amount of the zinc layer present on the zinc-magnesium alloy coating layer is small, and blackening resistance may be inferior.

### [Description of Reference Numerals]

- 100, 200:: STEEL SHEET
- 110:: HOT-DIP GALVANIZED LAYER
- 210:: ZINC COATING LAYER
- 220:: ZINC-MAGNESIUM ALLOY COATING LAYER
- 221, 222:: ZINC LAYER

## Claims

1. A heterogeneous coated steel sheet having excellent workability and corrosion resistance, comprising:
a steel sheet;
a zinc coating layer attached to one side of the steel sheet; and
a zinc-magnesium alloy coating layer attached to the other side of the steel sheet,
wherein a coating adhesion amount of the zinc coating layer is 5 to 60 g/m²,
a coating adhesion amount of the zinc-magnesium alloy coating layer is 10 to 40 g/m², and
a magnesium content of the zinc-magnesium alloy coating layer is 8 to 30 wt%.

2. The heterogeneous coated steel sheet having excellent workability and corrosion resistance of claim 1, wherein the zinc-magnesium alloy coating layer has a multilayer structure of two or more layers.

3. The heterogeneous coated steel sheet having excellent workability and corrosion resistance of claim 1, further comprising a zinc layer between the steel sheet and the zinc-magnesium alloy coating layer.

4. The heterogeneous coated steel sheet having excellent workability and corrosion resistance of claim 3, wherein a coating adhesion amount of the zinc layer is 3 g/m² or more.

5. The heterogeneous coated steel sheet having excellent workability and corrosion resistance of claim 1, further comprising a zinc layer on the zinc-magnesium alloy coating layer.

6. The heterogeneous coated steel sheet having excellent workability and corrosion resistance of claim 5, wherein a coating adhesion amount of the zinc layer is 10 g/m² or more and 20 g/m² or less.

7. The heterogeneous coated steel sheet having excellent workability and corrosion resistance of claim 1, wherein a corrosion potential of the zinc-magnesium alloy coating layer is -1.07 to -1.13 V(SCE).

8. A method of manufacturing a heterogeneous coated steel sheet having excellent workability and corrosion resistance, the method comprising:
preparing a steel sheet;
levitating a coating material by electromagnetic force in a vacuum chamber to generate zinc deposition vapor, and forming a zinc coating layer having an adhesion amount of 5 to 60 g/m² on one surface of the steel sheet by inducing and ejecting the zinc deposition vapor; and
generating zinc-magnesium alloy deposition vapor by levitating a coating material by electromagnetic force in a vacuum chamber, and forming a zinc-magnesium alloy coating layer having an adhesion amount of 10 to 40 g/m² on the other surface of the steel sheet by inducing and ejecting the zinc-magnesium alloy deposition vapor,
wherein a Mg content contained in the zinc-magnesium alloy deposition vapor is 8 to 30 weight%.

9. The method of manufacturing a heterogeneous coated steel sheet having excellent workability and corrosion resistance of claim 8, wherein the forming of the zinc coating layer and the forming of the zinc-magnesium alloy coating layer are sequentially performed regardless of an order, or are simultaneously performed.

10. The method of manufacturing a heterogeneous coated steel sheet having excellent workability and corrosion resistance of claim 8, further comprising forming a zinc layer before and/or after forming the zinc-magnesium alloy coating layer.

11. The method of manufacturing a heterogeneous coated steel sheet having excellent workability and corrosion resistance of claim 10, wherein the zinc layer is formed by generating zinc deposition vapor by levitating a coating material by electromagnetic force in a vacuum chamber and by inducing and ejecting the zinc deposition vapor.
